# EUROPEAN PATENT SPECIFICATION

(11) **EP 1 801 896 B1**
(45) Date of publication and mention of the grant of the patent: **19.05.2010**
(21) Application number: 05112912.0
(22) Date of filing: 23.12.2005
(51) Int. Cl.: H01L 45/00, H01L 27/24

(54) **Process for manufacturing a selection device with reduced current leakage, and selection device, in particular for phase change memory devices**
Verfahren zur Herstellung eines Auswahl-Bauelements mit reduziertem Leckstrom, sowie ein Auswahl-Bauelement, insbesondere für Phasenwechsel-Speicher
Procédé de fabrication d'un dispositif de sélection ayant un courant de fuite réduit, et un dispositif de sélection, notamment pour des dispositifs mémoires à changement de phase

(43) Date of publication of application: 27.06.2007
(73) Proprietor: STMicroelectronics Srl, 20041 Agrate Brianza (MB) (IT)
(72) Inventor: Dennison, Charles, 95138, SAN JOSE CA (US); Peters, John, 95014, CUPERTINO CA (US)
(74) Representative: Jorio, Paolo

(56) References cited:
- US-A- 4 845 533
- US-A- 5 177 567
- US-A- 6 153 890
- US-A1- 2004 183 107
- US-A1- 2005 029 627
- US-A1- 2006 073 655

## Description

This invention relates to a process for manufacturing a selection device with reduced current leakage and to the relative selection device; in particular the invention relates to a selection device for phase change memory devices, without being limited thereto.

As known, phase change materials are materials that may be switched between a generally amorphous and a generally crystalline state or between different detectable states of local order across the entire spectrum between completely amorphous and completely crystalline states. Thus, phase change materials have electrical properties (e.g. resistance, capacitance, etc.) that may be changed through the application of energy such as, for example, heat, light, voltage potential, or electrical current.

The state of the phase change materials is also non-volatile in that, when set in either a crystalline, semi-crystalline, amorphous, or semi-amorphous state representing a resistance value, that value is retained until changed by another programming event, as that value represents a phase or physical state of the material (e.g., crystalline or amorphous). The state is unaffected by removing electrical power.

The phase change materials include a chalcogenide material, that is at least one element from column VI of the periodic table or one or more of the chalcogenic elements, e.g., any of the elements of tellurium, sulfur, or selenium.

Phase change memory devices comprise memory cells formed each by a memory element and a selection element. The memory element has generally a phase change material for storing the information. In some embodiments, the selection element is also made of a chalcogenic material having one single phase (generally amorphous, but sometimes crystalline) with two distinct regions of operation associated to different resistivities. Such a selection element, also called Ovonic Threshold Switch (OTS), has a high resistance, generally a higher resistance than the memory element. Therefore, when a memory cell is to be read, a voltage drop is applied to the cell that is insufficient to trigger the memory element when the latter is in its high resistance condition (associated with a digital "0" state), but is sufficient to drive the OTS in its low resistance condition when the memory element is already in its low resistance condition (associated with a digital "1" state).

A problem with present OTS resides in the peripheral leakage that can occur as a result of damage or contamination to the sidewalls of the OTS element during etch and subsequent processing. This is one of the most critical issues when an OTS is utilized as a circuit element, in particular in the off state (when a voltage is applied to it that is less than the threshold voltage). In particular, one of the concerns in the field regards the variability and the levels of these leakages.

US 5,177,567 discloses a thin-film structure for chalcogenide electrical switching devices according to the preamble of claim 11. This known structure has a chalcogenide region formed in an opening of an underlying insulating material layer so as to contact a carbon layer, with peripheral portions extending over the underlying insulating material layer, and an upper conductive region having a lower width than the chalcogenide region.

US 2005/0029627 discloses a damascene conductive line for contacting an underlying memory element including forming a stack including a chalcogenide layer sandwiched between a pair of conductive layers, and etching the stack to form islands covered by an insulator. In a different embodiment, only the upper conductive layer is initially etched, then a spacer is formed and used to etch the underlying chalcogenide layer and bottom conductive layer, so that at least the chalcogenide layer and bottom conductive layer are self-aligned.

The object of the invention is thus to provide a process for manufacturing a phase change memory cell having a selection device having a uniform and lower leakage.

According to the present invention, there are provided methods for forming a selection device, a selection device and a system, as defined respectively in claims 1, 6, 11 and 16.

For the understanding of the present invention, a preferred embodiment is now described, purely as a non-limitative example, with reference to the enclosed drawings, wherein:
- Figures 1 to 4 are cross-sections through one embodiment of the present invention in subsequent manufacturing steps, in accordance with a first embodiment of the present invention;
- Figure 5 is a cross-section of a different embodiment of the present invention;

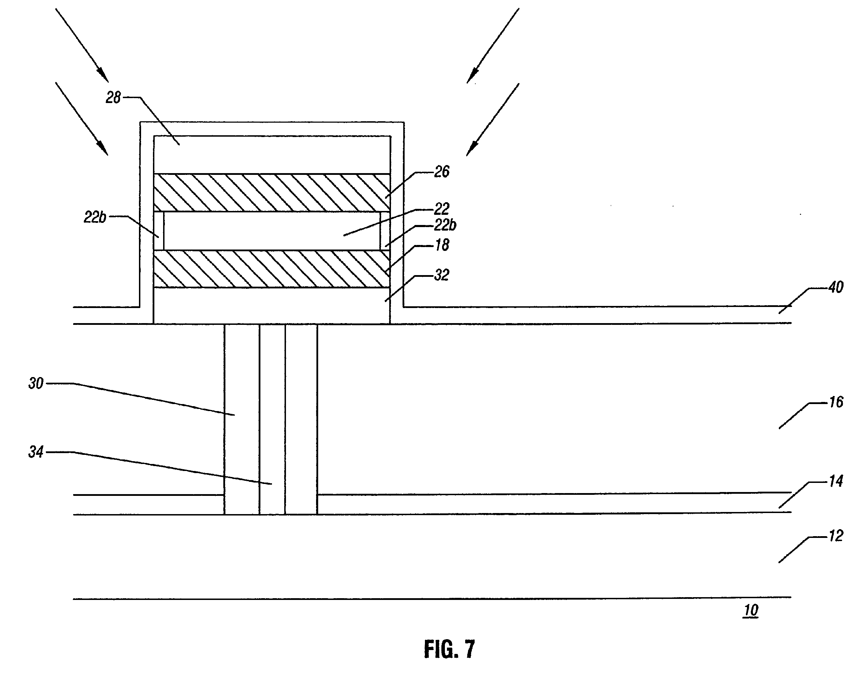

- Figures 6 and 7 are cross-sections of another embodiment of the present invention, in subsequent manufacturing steps; and
- Figure 8 is a system depiction for another embodiment of the invention.

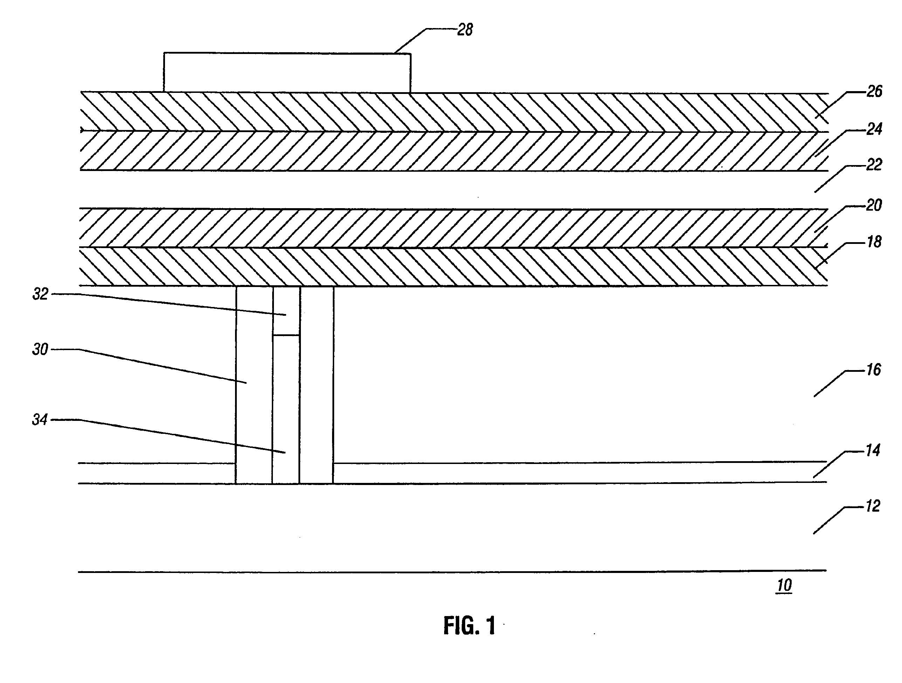

Referring to Figure 1, a phase change memory cell is formed of a stack including an ovonic unified memory element underlying a selection device in the form of an ovonic threshold switch. The ovonic unified memory element is formed on the substrate 10. A conductor 12 extends over the substrate 10. In a possible application, the phase change memory cell belongs to an array of memory cells arranged along rows and columns, the cells of a row being connected by conductor 12, acting as a row line conductor. In other applications, the conductor 12 is generally an electrode.

The stack of Figure 1 is obtained as follows. A pair of insulating layers 14 and 16 are formed over the conductor 12. The insulating layer 14 is here thinner than the insulating layer 16. Then, a pore or via hole is formed through the insulating layers 14 and 16. The via hole is then filled with a lance oxide 30, a lance heater 34, and a phase change memory element 32. Thus, the structure shown in Figure 1 is a damascene ovonic unified memory. The phase change memory element 32 is a chalcogenide.

Then, a lower electrode 18 is formed over the phase change memory element 32 and the insulating layer 16. The lower electrode 18 is here a common electrode acting as the top electrode of the ovonic unified memory and the bottom electrode of the overlying ovonic threshold switch. For example, the electrode 18 may be formed of titanium aluminium nitride or titanium and titanium nitride.

The, a stack comprising a first conductive layer 20, a chalcogenide layer 22 and second conductive layer 24 is formed over the electrode 18. The chalcogenide layer 22 does not change phase and is used to form the ovonic threshold switch. The conductive layers 20, 24 may be formed of carbon.

Finally, an upper electrode 26 is formed over the second conductive layer 24. The upper electrode 26 may be made of the same or different material as the lower electrode 18. Finally, a hard mask 28 is deposited and patterned over the structure.

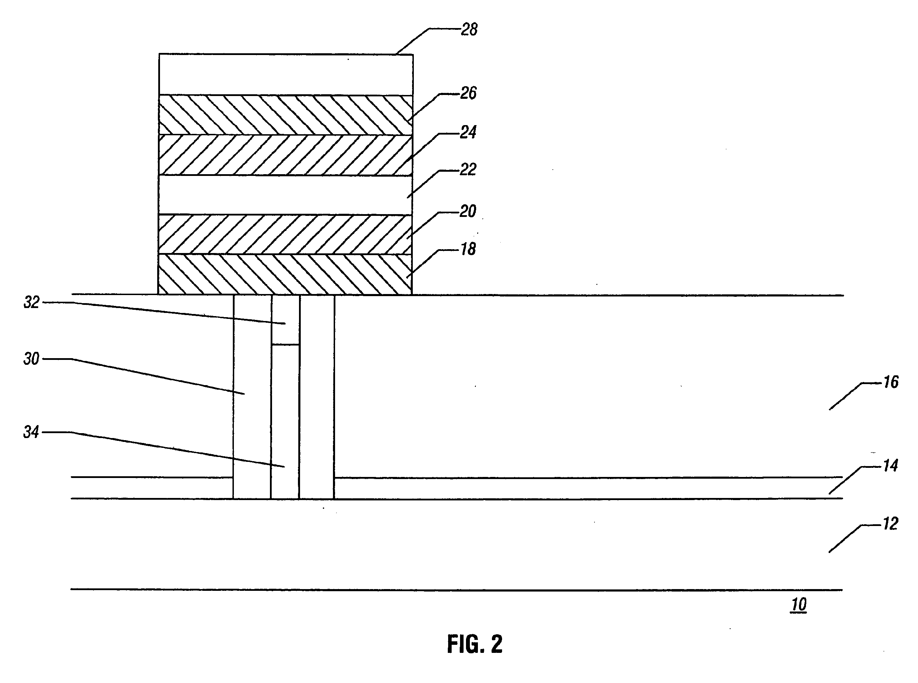

Referring to Figure 2, the hard mask 28 is utilized to etch a dot or reduced length stack of layers that correspond to the patterned dimensions of the hard mask 28. The hard mask 28 may be any material which is suitably resistant to the etching material utilized to form the dot or stack shown in Figure 2.

The dot or stack shown in Figure 2, forming an ovonic threshold switch, may be prone to current leakage during the off state. Because of the etch shown in Figure 2, leakage may occur because of the way the etching is done and/or leaving a residual etch polymer on the sidewall of chalcogenide layer 22 that may provide either a conductive shunt path or contaminate the material of the adjacent chalcogenide layer 22 such that it locally becomes more conductive.
The leakage may result in current passing around the chalcogenide layer 22, rendering the switch ineffective when it is off because it allows current to pass.

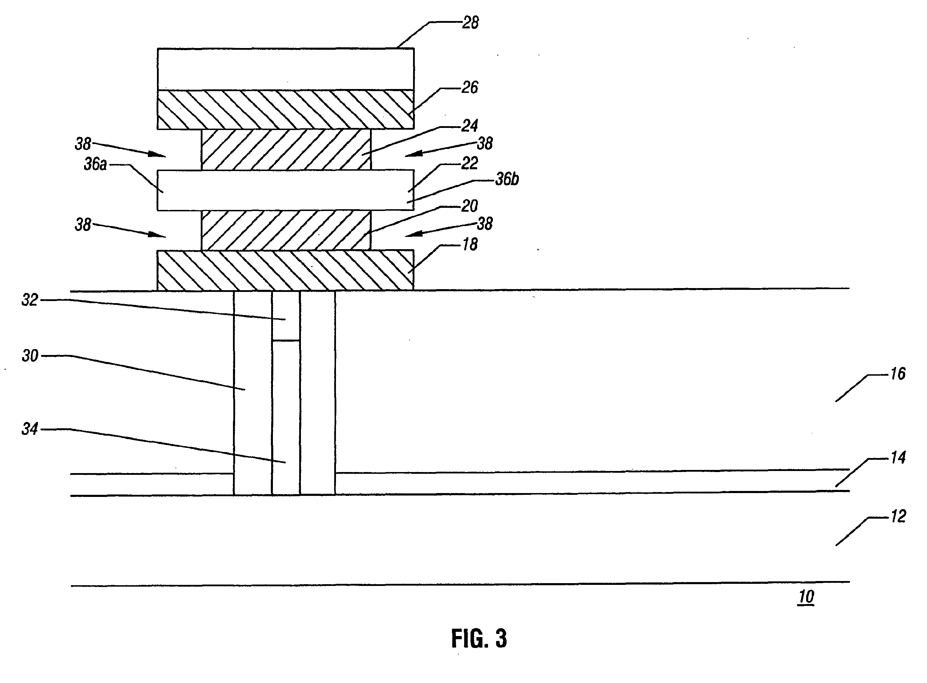

To solve this problem, an etch protocol is utilized, as shown in Figure 3, that causes undercutting or lateral etching of the conductive layers 20, 24. In other words, undercutting occurs at 38 in the conductive layers 20, 24, resulting in opposed protrusions in the intervening chalcogenide layer 22.

In one embodiment, the undercutting may utilize an oxygen plasma/etch step after already anisotropically etching the stack using the hard mask 28. However, in other embodiments, the isotropic undercutting may be formed while etching the stack.

In some embodiments, a suitable isotropic etch which preferably and selectively attacks the conductive layers 24 and 20 and does not attack the other layers as much, may be utilized. In other words, the etchant may be selective of the materials of the conductive layers 20 and 24.

Because of the undercuttings or setbacks, indicated at 38 in Figure 3, even if there is damage along the outstanding protrusions or edges 36b and 36a of the of the chalcogenide layer 22 forming an ovonic threshold switch, less leakage can occur between conductive layers 20 and 24 because of the setbacks 38 in each of the conductive layers 20 and 24. The physical spacing between the outer edges of the conductive layers 20 and 24 and etched edge of chalcogenide layer 22 is significantly increased and it is very difficult for conduction to occur past the outstanding protrusions 36a and 36b.

Thus, current leakage may be substantially reduced, improving the performance of the structure.

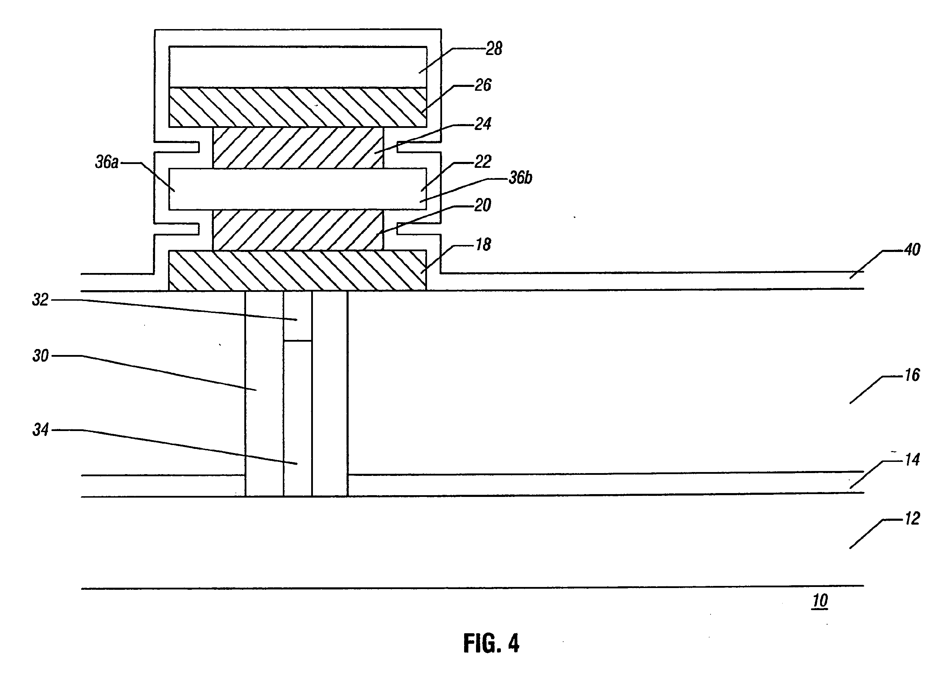

After completing the structure shown in Figure 3, the entire structure may then be coated with a suitable passivation layer 40 as shown in Figure 4. One such passivation layer 40 is a low temperature silicon nitride (Si₃N₄) encapsulation.

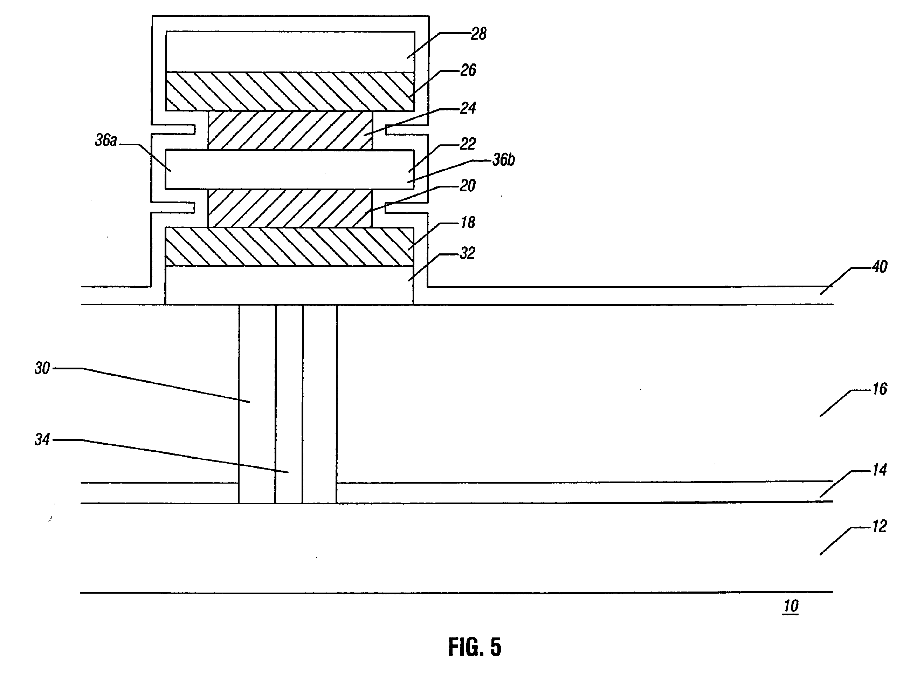

The techniques described herein may be applied to a variety of different phase change memory structures. Shown in Figure 5 is a similar structure in which the phase change memory element 32 is part of the stack that includes the ovonic threshold switch layer 22 and is etched with a common edge with all of those layers. Then, the heater 34 simply extends the entire height of the insulating layers 14 and 16 and is suitably insulated by the lance oxide 30.

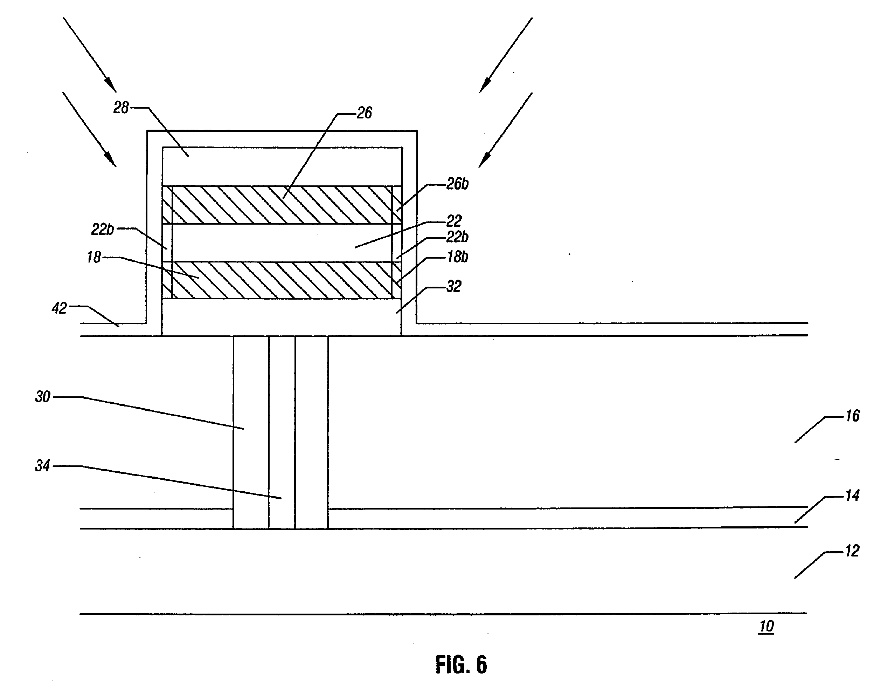

According to another embodiment, the structure is subject to an angled ion implant. Figure 6 shows a phase change memory device corresponding to the structure shown in Figure 5, wherein the phase change memory element 32 is part of the stack. Also, here, the first and second conductive layers 20 and 24 are not present. Other arrangements for the phase change memory can also be used, including the structure shown, for example, in Figure 4.

According to Figure 6, after the etch of figure 2 and the deposition of an optional insulating layer 42, the structure is subject to an angled ion implant, as indicated by arrows.

The optional layer 42 acts as a screening layer and is advantageously an insulator such as silicon nitride.

For example, in one embodiment, a 45° ion implant angle is utilized. The ions implant into outer perimeter edge of layers 18, 22 of the ovonic threshold switch material and of the upper electrode 26, forming regions 18b, 22b, 26b. The angled implant is optimized to increase the resistance of the regions 18b, 22b and 26b either by damage or knock-on from the screening layer or by actual implantation of insulating ions such as oxygen and/or nitrogen. Region 22b prevents conduction from the edge regions of the overlying and underlying electrodes 18 and 26. Increasing resistance of regions 18b and 26b effectively reduces the conductive area of the lower and upper electrodes and minimize any effect that a lower resistance shunt at the edge of chalcogenide layer 22 will have on the total device structure. As a result, leakage current along the periphery of the device may be reduced.

The implant is also useful to prevent the device from early, undesirable firing along the edge of the device and so significantly improve the consistency of parameters such as threshold voltage.

In some embodiments, the implanted species are a material that has insulative properties such as oxygen or nitrogen. In this case, the implant alters the composition of the sidewalls of the chalcogenide layer 22, as well as the peripheral regions of the upper and lower electrodes 26 and 18. The range of the implant may be selected to be deep enough that the implant penetrates through the screening layer 42 into the sidewall of the layer 22 to form the regions 22b. The implant is here angled and may be of high dose in order to change the conductive properties along the periphery of the structure.

In some embodiments, the screening layer 42 is removed and a new passivation layer 40 used in its place. In other embodiments, the screening layer 42 is sufficient to act as the passivation layer; furthermore, the screening layer 42 may be augmented with the deposition of additional material.

A series connected selection device in the form of the ovonic threshold switch shown therein is advantageously used to access a memory element, formed by the phase change memory element 32, during programming or reading of memory element. Thus, the selection device is an ovonic threshold switch that is made of a chalcogenide alloy that does not exhibit an amorphous to crystalline phase change and which undergoes rapid, electric field initiated change in electrical conductivity that persists only so long as a holding voltage is present.

The selection device operates as a switch that is either "off" or "on" depending on the amount of voltage potential applied across the memory cell, and more particularly whether the current through the selection device exceeds its threshold current or voltage, which then triggers the device into the on state. The off state is a substantially electrically nonconductive state and the on state is a substantially conductive state, with less resistance than the off state.

In the on state, the voltage across the selection device is equal to its holding voltage VH plus IxRon, where Ron is the dynamic resistance from the extrapolated X-axis intercept, VH. For example, a selection device has threshold voltages and, if a voltage potential less than the threshold voltage of a selection device is applied across the selection device, then the selection device remains "off" or in a relatively high resistive state so that little or no electrical current passes through the memory cell and most of the voltage drop from selected row to selected column is across the selection device. Alternatively, if a voltage potential greater than the threshold voltage of a selection device is applied across the selection device, then the selection device "turns on," i.e., operate in a relatively low resistive state so that electrical current passes through the memory cell. In other words, one or more series connected selection devices are in a substantially electrically nonconductive state if less than a predetermined voltage potential, e.g., the threshold voltage, is applied across them. Selection devices may be in a substantially conductive state if greater than the predetermined voltage potential is applied across them. Selection devices may also be referred to as access devices, isolation devices, or switches.

Each selection device comprises a switching material of a chalcogenide alloy. The switching material of selection devices is a material in a substantially amorphous state positioned between two electrodes that may be repeatedly and reversibly switched between a higher resistance "off" state (e.g., greater than about ten megaOhms) and a relatively lower resistance "on" state (e.g., about one thousand Ohms in series with VH) by application of a predetermined electrical current or voltage potential.

In this embodiment, each selection device is a two terminal device that has a current-voltage (I-V) characteristic similar to a phase change memory element that is in the amorphous state. However, unlike a phase change memory element, the switching material of selection devices does not change phase. That is, the switching material of selection devices may not be a programmable material, and, as a result, selection devices may not be a memory device capable of storing information. For example, the switching material of selection devices may remain permanently amorphous and the I-V characteristic may remain the same throughout the operating life.

In the low voltage or low electric field mode, i.e., where the voltage applied across selection device is less than a threshold voltage (labeled VTH), a selection device is "off" or non-conducting, and exhibits a relatively high resistance, e.g., greater than about 10 megaOhms. The selection device remains in the off state until a sufficient voltage, e.g., VTH, is applied, or a sufficient current is applied, e.g., ITH, that switches the selection device to a conductive, relatively low resistance on state. After a voltage potential of greater than about VTH is applied across the selection device, the voltage potential across the selection device drops ("snapbacks") to a holding voltage potential, VH. Snapback may refer to the voltage difference between VTH and VH of a selection device.

In the on state, the voltage potential across the selection device remains close to the holding voltage of VH as current passing through selection device is increased. The selection device remains on until the current through the selection device drops below a holding current, IH. Below this value, the selection device turns off and returns to a relatively high resistance, nonconductive off state until the VTH and ITH are exceeded again.

In some embodiments, only one selection device is used. In other embodiments, more than two selection devices are used. A single selection device has a VH about equal to its threshold voltage, VTH, (a voltage difference less than the threshold voltage of the memory element) to avoid triggering a reset bit when the selection device triggers from a threshold voltage to a lower holding voltage called the snapback voltage. As another example, the threshold current of the memory element may be about equal to the threshold current of the access device even though its snapback voltage is greater than the memory element's reset bit threshold voltage.

Programming of the phase change memory element 32 to alter the state or phase of the material is generally accomplished by applying voltage potentials to the conductor 12 and upper electrode 26, thereby generating a voltage potential across the selection device and memory element. When the voltage potential is greater than the threshold voltages of selection device and memory element, then an electrical current flows through the phase change memory element 32 in response to the applied voltage potentials, and may result in heating of the phase change memory element 32.

This heating may alter the memory state or phase of the phase change memory element 32 and thus the electrical characteristic of memory material, e.g., the resistance of the material may be altered by altering the phase of the memory material.

In the "reset" state, memory material is in an amorphous or semi-amorphous state and in the "set" state, memory material is in a crystalline or semi-crystalline state. The resistance of memory material in the amorphous or semi-amorphous state is greater than the resistance of memory material in the crystalline or semi-crystalline state. It is to be appreciated that the association of reset and set with amorphous and crystalline states, respectively, is a convention and that at least an opposite convention may be adopted.

Using electrical current, memory material is heated to a relatively higher temperature to amorphosize memory material and "reset" memory material (e.g., program memory material to a logic "0" value). Heating the volume of memory material to a relatively lower crystallization temperature crystallizes the memory material and "sets" memory material (e.g., program memory material to a logic "1" value). Various resistances of memory material may be achieved to store information by varying the amount of current flow and duration through the volume of memory material.

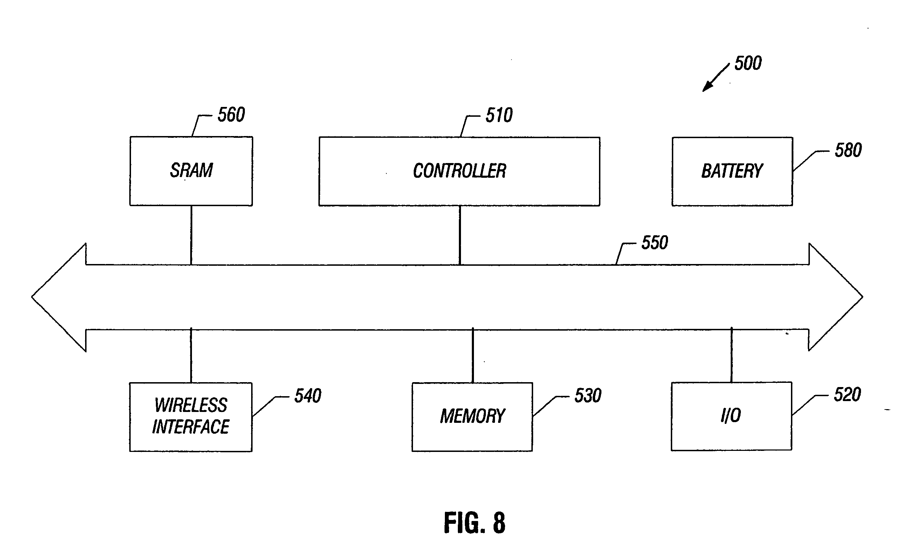

Turning to Figure 8, a portion of a system 500 in accordance with an embodiment of the present invention is described. System 500 may be used in wireless devices such as, for example, a personal digital assistant (PDA), a laptop or portable computer with wireless capability, a web tablet, a wireless telephone, a pager, an instant messaging device, a digital music player, a digital camera, or other devices that may be adapted to transmit and/or receive information wirelessly. System 500 may be used in any of the following systems: a wireless local area network (WLAN) system, a wireless personal area network (WPAN) system, a cellular network, although the scope of the present invention is not limited in this respect.

System 500 includes a controller 510, an input/output (I/O) device 520 (e.g. a keypad, display), static random access memory (SRAM) 560, a memory 530, and a wireless interface 540 coupled to each other via a bus 550. A battery 580 is used in some embodiments. It should be noted that the scope of the present invention is not limited to embodiments having any or all of these components.

Controller 510 comprises, for example, one or more microprocessors, digital signal processors, microcontrollers, or the like. Memory 530 may be used to store messages transmitted to or by system 500. Memory 530 may also optionally be used to store instructions that are executed by controller 510 during the operation of system 500, and may be used to store user data. Memory 530 may be provided by one or more different types of memory. For example, memory 530 may comprise any type of random access memory, a volatile memory, a non-volatile memory such as a flash memory and/or a memory such as memory discussed herein.

I/O device 520 may be used by a user to generate a message. System 500 uses wireless interface 540 to transmit and receive messages to and from a wireless communication network with a radio frequency (RF) signal. Examples of wireless interface 540 may include an antenna or a wireless transceiver, although the scope of the present invention is not limited in this respect.

References throughout this specification to "one embodiment" or "an embodiment" mean that a particular feature, structure, or characteristic described in connection with the embodiment is included in at least one implementation encompassed within the present invention. Thus, appearances of the phrase "one embodiment" or "in an embodiment" are not necessarily referring to the same embodiment. Furthermore, the particular features, structures, or characteristics may be instituted in other suitable forms other than the particular embodiment illustrated.

## Claims

1. A method for forming a selection device for a memory cell, the selection device comprising a chalcogenide layer (22) having one single phase that does not change phase during operation, comprising:
forming a stack comprising a first conductive layer (20; 18); the chalcogenide layer (22), extending on the first conductive layer without any intermediate insulating layer, at least in the area where the selection device is to be formed; and a second conductive layer (24; 26) extending on said chalcogenide layer (22), thereby the first and second conductive layers extend on either side of the chalcogenide layer; and
forming a mask (28) over said stack,
**characterized by** the step of:
after forming a mask, forming a reduced conduction structure (20, 36a, 36b, 24) reducing conduction between said conductive layers in peripheral portions (36a, 36b) of said chalcogenide layer (22), wherein forming a reduced conduction structure includes etching said stack including both said conductive layers (18, 20, 24, 26) and said chalcogenide layer (22) using said mask (28), etching including undercutting at least one of said conductive layers (20, 24) so that said chalcogenide layer (22) extends outwardly beyond said at least one undercut conductive layer.

2. The method of claim 1, wherein etching a stack includes anisotropically etching said stack and isotropically etching said conductive layers (20, 21).

3. The method of claim 1 or 2, wherein said conductive layers are of carbon.

4. The method of any of claims 1-3, including using an oxygen plasma etch to undercut said conductive layers (20, 24).

5. The method of claim 3, including first etching said stack using an anisotropic etch and subsequently etching said conductive layers (20, 24) isotropically.

6. A method for forming a selection device for a memory cell, the selection device comprising a chalcogenide layer (22) having one single phase that does not change phase during operation, comprising:
forming said selection device with a pair of conductive layers (18, 26) on either side of the chalcogenide layer (22);
**characterized by** the step of:
forming a reduced conduction structure (18b, 22b, 26b) reducing conduction between said conductive layers in peripheral portions of said chalcogenide layer,
wherein forming a reduced conduction structure includes damaging said conductive layers (18, 26) using ion implantation.

7. The method of claim 6 including damaging conductive layers said (18,26) and said chalcogenide layer (22) by an angled ion implantation.

8. The method of claim 7, comprising after etching said conductive layers (18, 26) and chalcogenide layer (22), exposing said stack to an angled ion implantation of an electrically insulative material.

9. The method of claim 8, wherein exposing said stack to an angled ion implantation comprises implanting an insulative material.

10. The method of claim 8, comprising forming a screening layer (42) covering said stack before exposing said stack to an angled ion implantation.

11. A device including a selection device for a memory cell, the selection device comprising a chalcogenide layer (22) having one single phase that does not change phase during operation, a pair of conductive layers (20, 24; 18, 26) sandwiching said chalcogenide layer, and a reduced conduction structure (20, 24, 36a, 36b; 18b, 22b, 26b) reducing conduction between said conductive layers in peripheral portions (36a, 36b; 22b) of said chalcogenide layer (22), **characterized in that** either said chalcogenide layer (22) has protruding portions (36a, 36b) that extend beyond both said conductive layers (20, 24), or said reduced conduction structure (18b, 22b, 26b) includes peripheral portions (22b) of said chalcogenide layer (22) that are ion implanted.

12. The device of claim 11, wherein said conductive layers (20, 24) include carbon.

13. The device of claim 11 or 12, wherein said ion-implanted peripheral portions (22b) of said chalcogenide layer (22) contain an insulative dopant and are insulative.

14. The device of any of claims 11-13, wherein said chalcogenide layer (22) is part of an ovonic threshold switch.

15. The device of any of claims 11-14, forming a phase change memory device including a memory element (32) of a chalcogenic material series-connected to said selection device.

16. A system comprising:
a processor (510);
an input/output device (520) coupled to said processor; and
a memory (530) coupled to said processor, said memory including the device according to claim 15.

## Patentansprüche

1. Verfahren zum Bilden einer Auswahlvorrichtung für eine Speicherzelle, wobei die Auswahlvorrichtung eine Chalkogenid-Schicht (22) mit einer einzigen Phase aufweist, die keine Phasenänderung während des Betriebs ausführt,
wobei das Verfahren folgende Schritte aufweist:
Bilden eines Stapels, aufweisend eine erste leitfähige Schicht (20; 18); die Chalkogenid-Schicht (22), die sich auf der ersten leitfähigen Schicht ohne jegliche zwischengeordnete Isolierschicht zumindest in dem Bereich erstreckt, in dem die Auswahlvorrichtung zu bilden ist; und eine zweite leitfähige Schicht (24; 26), die sich auf der Chalkogenid-Schicht (22) erstreckt, so dass sich die erste und die zweite leitfähige Schicht auf beiden Seiten der Chalkogenid-Schicht erstrecken; und
Bilden einer Maske (28) über dem Stapel,
**gekennzeichnet durch** folgenden Schritt:
nach dem Bilden der Maske erfolgendes Bilden einer Struktur (20, 36a, 36b, 24) mit reduzierter Leitfähigkeit, die die Leitfähigkeit zwischen den leitfähigen Schichten in peripheren Bereichen (36a, 36b) der Chalkogenid-Schicht (22) reduziert, wobei das Bilden der Struktur mit reduzierter Leitfähigkeit das Ätzen des Stapels, der die beiden leitfähigen Schichten (18, 20, 24, 26) und
die Chalkogenid-Schicht (22) beinhaltet, unter Verwendung der Maske (28) beinhaltet, wobei das Ätzen das Hinterschneiden von mindestens einer der leitfähigen Schichten (20, 24) beinhaltet, so dass die Chalkogenid-Schicht (22) sich nach außen über die mindestens eine hinterschnittene Schicht hinaus erstreckt.

2. Verfahren nach Anspruch 1,
wobei das Ätzen eines Stapels das anisotrope Ätzen des Stapels und und das isotrope Ätzen der leitfähigen Schichten (20, 24) beinhaltet.

3. Verfahren nach Anspruch 1 oder 2,
wobei die leitfähigen Schichten aus Kohlenstoff bestehen.

4. Verfahren nach einem der Ansprüche 1 bis 3,
das die Verwendung von Sauerstoffplasma zum Hinterschneiden der leitfähigen Schichten (20, 24) beinhaltet.

5. Verfahren nach Anspruch 3,
das als erstes das Ätzen des Stapels unter Verwendung eines anisotropen Ätzvorgangs und anschließend das Ätzen der leitfähigen Schichten (20, 24) in isotroper Weise beinhaltet.

6. Verfahren zum Bilden einer Auswahlvorrichtung für eine Speicherzelle, wobei die Auswahlvorrichtung eine Chalkogenid-Schicht (22) mit einer einzigen Phase aufweist, die keine Phasenänderung während des Betriebs ausführt,
wobei das Verfahren folgende Schritte aufweist:
Bilden der Auswahlvorrichtung mit einem Paar leitfähiger Schichten (18, 26) auf beiden Seiten der Chalkogenid-Schicht (22);
**gekennzeichnet durch** folgenden Schritt:
Bilden einer Struktur (18b, 22b, 26b) mit reduzierter Leitfähigkeit, die die Leitfähigkeit zwischen den leitfähigen Schichten in peripheren Bereichen der Chalkogenid-Schicht reduziert, wobei das Bilden der Struktur mit reduzierter Leitfähigkeit das Beschädigen der leitfähigen Schichten (18, 26) mittels lonenimplantation beinhaltet.

7. Verfahren nach Anspruch 6,
das das Beschädigen der leitfähigen Schichten (18, 26) und der Chalkogenid-Schicht (22) durch lonenimplantation in einem Winkel beinhaltet.

8. Verfahren nach Anspruch 7,
das nach dem Ätzen der leitfähigen Schichten (18, 26) und der Chalkogenid-Schicht (22) den Schritt aufweist, in dem der Stapel einer in einem Winkel erfolgenden lonenimplantation eines elektrisch isolierenden Materials unterzogen wird.

9. Verfahren nach Anspruch 8,
wobei der Schritt, in dem der Stapel einer lonenimplantation in einem Winkel unterzogen wird, das Implantieren eines isolierenden Materials beinhaltet.

10. Verfahren nach Anspruch 8,
das das Bilden einer den Stapel überdeckenden Abschirmschicht (42) beinhaltet, bevor der Stapel einer Ionenimplantation in einem Winkel unterzogen wird.

11. Vorrichtung mit einer Auswahlvorrichtung für eine Speicherzelle, wobei die Auswahlvorrichtung aufweist: eine Chalkogenid-Schicht (22) mit einer einzigen Phase, die keine Phasenänderung während des Betriebs ausführt, ein Paar leitfähiger Schichten (20, 24; 18, 26), die die Chalkogenid-Schicht (22) zwischen sich schließen, und eine Struktur (20, 24, 36a, 36b; 18b, 22b, 26b) mit reduzierter Leitfähigkeit, die die Leitfähigkeit zwischen den leitfähigen Schichten in peripheren Bereichen (36a, 36b; 22b) der Chalkogenid-Schicht reduziert,
**dadurch gekennzeichnet, dass** entweder die Chalkogenid-Schicht (22) vorstehende Bereiche (36a, 36b) aufweist, die sich über die beiden leitfähigen Schichten (20, 24) hinaus erstrecken, oder die Struktur (18b, 22b, 26b) mit reduzierter Leitfähigkeit periphere Bereiche (22b) der Chalkogenid-Schicht (22) aufweist, die einer lonenimplantation unterzogen worden sind.

12. Vorrichtung nach Anspruch 11,
wobei die leitfähigen Schichten (20, 24) Kohlenstoff beinhalten.

13. Vorrichtung nach Anspruch 11 oder 12,
wobei die ionenimplantierten peripheren Bereiche (22b) der Chalkogenid-Schicht (22) einen isolierenden Dotierstoff beinhalten und isolierend sind.

14. Vorrichtung nach einem der Ansprüche 11 bis 13,
wobei die Chalkogenid-Schicht (22) Teil eines Ovonic-Schwellenwertschalters ist.

15. Vorrichtung nach einem der Ansprüche 11 bis 14,
die eine Phasenänderungs-Speichervorrichtung mit einem Speicherelement (32) aus einem chalkogenen Material in Reihenschaltung mit der Auswahlvorrichtung bildet.

16. System, aufweisend:
einen Prozessor (510);
eine Eingabe/Ausgabevorrichtung (520), die mit dem Prozessor gekoppelt ist; und
einen Speicher (530), der mit dem Prozessor gekoppelt ist, wobei der Speicher die Vorrichtung gemäß Anspruch 15 beinhaltet.

## Revendications

1. Procédé de formation d'un dispositif de sélection pour une cellule de mémoire, le dispositif de sélection comprenant une couche de chalcogénure (22) ayant une seule phase qui ne change pas de phase en fonctionnement, consistant à :
former une pile comprenant une première couche conductrice (20 ; 18) ; la couche de chalcogénure (22) s'étendant sur la première couche conductrice sans aucune couche isolante intermédiaire, au moins dans la zone dans laquelle le dispositif de sélection doit être formé ; et une deuxième couche conductrice (24 ; 26) s'étendant sur ladite couche de chalcogénure (22), les première et deuxième couches conductrices s'étendant de ce fait de chaque côté de la couche de chalcogénure ; et
former un masque (28) sur ladite pile,
**caractérisé par** l'étape consistant à :
après avoir formé un masque, former une structure à conduction réduite (20, 36a, 36b, 24) réduisant la conduction entre lesdites couches conductrices dans des parties périphériques (36a, 36b) de ladite couche de chalcogénure (22), dans lequel la formation d'une structure de conduction réduite comprend la gravure de ladite pile comprenant lesdites deux couches conductrices (18, 20, 24, 26) et ladite couche de chalcogénure (22) en utilisant ledit masque (28), la gravure comprenant le dégagement d'au moins l'une desdites couches conductrices (20, 24) de sorte que ladite couche de chalcogénure (22) s'étende vers l'extérieur au-delà de ladite au moins une couche conductrice dégagée.

2. Procédé selon la revendication 1, dans lequel la gravure d'une pile comprend la gravure anisotrope de ladite pile et la gravure isotrope desdites couches conductrices (20, 24).

3. Procédé selon la revendication 1 ou 2, dans lequel lesdites couches conductrices sont en carbone.

4. Procédé selon l'une quelconque des revendications 1 à 3, comprenant l'utilisation d'une gravure à plasma d'oxygène pour dégager lesdites couches conductrices (20, 24).

5. Procédé selon la revendication 3, comprenant d'abord la gravure de ladite pile en utilisant une gravure anisotrope et ensuite la gravure isotrope desdites couches conductrices (20, 24).

6. Procédé de formation d'un dispositif de sélection pour une cellule de mémoire, le dispositif de sélection comprenant une couche de chalcogénure (22) ayant une seule phase qui ne change pas de phase en fonctionnement, consistant à :
former ledit dispositif de sélection avec une paire de couches conductrices (18, 26) de chaque côté de la couche de chalcogénure (22) ;
**caractérisé par** l'étape consistant à :
former une structure à conduction réduite (18b, 22b, 26b) réduisant la conduction entre lesdites couches conductrices dans des parties périphériques de ladite couche de chalcogénure,
dans lequel la formation d'une structure à conduction réduite comprend l'endommagement desdites couches conductrices (18, 26) en utilisant une implantation ionique.

7. Procédé selon la revendication 6, comprenant l'endommagement desdites couches conductrices (18, 26) et de ladite couche de chalcogénure (22) par une implantation ionique inclinée.

8. Procédé selon la revendication 7, comprenant, après la gravure desdites couches conductrices (18, 26) et de ladite couche de chalcogénure (22), l'exposition de ladite pile à une implantation ionique inclinée d'un matériau électriquement isolant.

9. Procédé selon la revendication 8, dans lequel l'exposition de ladite pile à une implantation ionique inclinée comprend l'implantation d'un matériau isolant.

10. Procédé selon la revendication 8, comprenant la formation d'une couche de protection (42) recouvrant ladite pile avant l'exposition de ladite pile à une implantation ionique inclinée.

11. Dispositif comprenant un dispositif de sélection pour une cellule de mémoire, le dispositif de sélection comprenant une couche de chalcogénure (22) ayant une seule phase qui ne change pas de phase en fonctionnement, une paire de couches conductrices (20, 24 ; 18, 26) de part et d'autre de ladite couche de chalcogénure, et une structure à conduction réduite (20, 24, 36a, 36b, 18b, 22b, 26b) réduisant la conduction entre lesdites couches conductrices dans des parties périphériques (36a, 36b ; 22b) de ladite couche de chalcogénure (22), **caractérisé en ce que** soit ladite couche de chalcogénure (22) comporte des parties saillantes (36a, 36b) qui s'étendent au-delà desdites deux couches conductrices (20, 24), soit ladite structure à conduction réduite (18b, 22b, 26b) comprend des parties périphériques (22b) de ladite couche de chalcogénure (22) dans lesquelles des ions sont implantés.

12. Dispositif selon la revendication 11, dans lequel lesdites couches conductrices (20, 24) comprennent du carbone.

13. Dispositif selon la revendication 11 ou 12, dans lequel lesdites parties périphériques (22b) dans lesquelles des ions sont implantés de ladite couche de chalcogénure (22) contiennent un dopant isolant et sont isolantes.

14. Dispositif selon l'une quelconque des revendications 11 à 13, dans lequel ladite couche de chalcogénure (22) fait partie d'un commutateur à seuil ovonique.

15. Dispositif selon l'une quelconque des revendications 11 à 14, formant un dispositif de mémoire à changement de phase comprenant un élément de mémoire (32) en un matériau chalcogénique connecté en série avec ledit dispositif de sélection.

16. Système comprenant :
un processeur (510) ;
un dispositif d'entrée/sortie (520) couplé audit processeur ; et
une mémoire (530) couplée audit processeur, ladite mémoire comprenant le dispositif selon la revendication 15.
